# EUROPEAN PATENT APPLICATION

(11) **EP 0 897 021 A1**
(43) Date of publication of application: **17.02.1999**
(21) Application number: 98104223.7
(22) Date of filing: 10.03.1998
(51) Int. Cl.: C23C 14/04, A44C 17/00, C30B 33/00

(54) **Process and device for marking gems and product obtained**

(30) Priority: 05.08.1997 IT MI971888
(71) Applicant: Gemmindustria Gaia Ferrando S.p.A., 20122 Milano (IT)
(72) Inventor: Gaia, Mario, 20060 Cassina De' Pecchi, Milano (IT)
(74) Representative: Zavattoni Gusmeroli, Maria Chiara

(57) **Abstract**

To mark gems, such as pearls and precious stones, with a barely visible mark, such as not to impair the beauty thereof yet able to provide a set of information, for certification purposes for example, a process has been devised which uses deposition of a marking material in the vapor phase on selected areas of the surface of the gem. The deposit is then fixed by means of a protective varnish. A particular device (10) has also been designed for the procedure.

## Description

In the field of jewelry and gemmology there has long been a need to provide a certification for individual gems that is able to establish a reciprocal unique match between a certain gem and the relative certificate. At present gems are supplied with a certificate of guarantee which has no counterpart, however, on the particular gem, so it could be attached to a different gem from that certified. Another need is to distinguish a gem of a certain origin, or from a certain supplier, from others.

The state of the art, in another field, includes deposition of thin films of metal in the vapor phase on a substrate, in vacuum; these processes are applied, for example, for silver plating of spotlights and the like.

These processes, in their known form, cannot be applied to gems because they would disfigure them irreparably.

The aim of this invention is to allow application to a gem of an identifying mark that is able to provide a sufficient amount of information yet is of such a size as not to detracting from the beauty of the gem.

This object has been achieved with a procedure as claimed in claim 1. The invention also relates to a gem thus marked, produced with the procedure of the invention. The invention also relates to a particular device as claimed in claim 14 for use in combination with the process of claim 1.

The new procedure arranging the gems to be marked into a device, comprising a mask with perforations, preferably laser microperforations; introducting the device into a vacuum chamber provided with a heatable crucible or melting pot in which a material to be used for marking is placed; creating a vacuum in the vacuum chamber; raising the temperature of the gem to evaporate any water still present; heating the vacuum chamber to create a plasma for surface cleaning of the gem; vaporizing at least part of the marking material and depositing the vaporized marking material on the gem areas left free by the perforations in the mask.

The new procedure makes it possible to achieve reliable marking of gems but without marring their overall appearance.

The process of the invention, together with the means necessary to carry it out, will be described hereinunder in greater detail with reference to the appended drawings, in which, only by way of non-limiting example, a supporting device for pearls to be marked that can be used with the procedure of the invention, is shown;

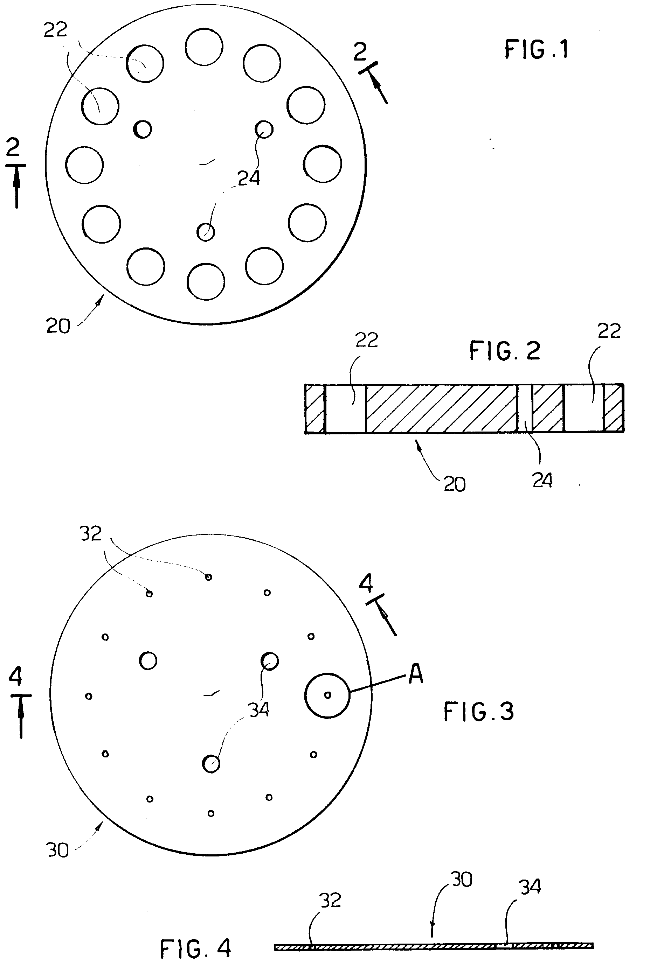

Figure 1 is a top plan view of a device provided with twelve housings for gems, in particular pearls;
Figure 2 is a sectional view along 2-2 in Figure 1;
Figure 3 is a top plan view of a marking mask for the device and the procedure of the invention;
Figure 4 is a sectional view along 4-4 in Figure 3;
Figure 5 is a top plan view of a detail A circled in Figure 3, greatly enlarged;
Figure 6 is a top plan view of a cover of the device;
Figure 7 is a vertical sectional view along 7-7 in Figure 6;

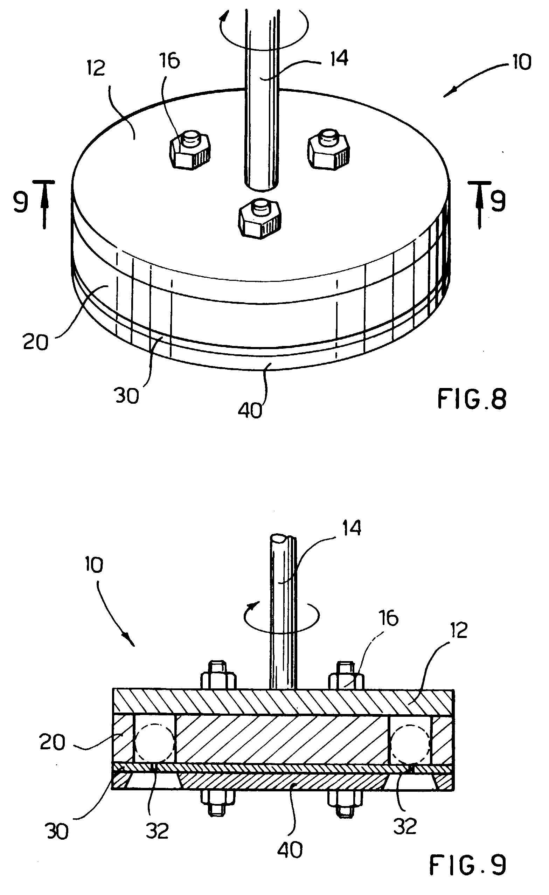

Figure 8 is a perspective view of the device assembled for use in the procedure;
Figure 9 is a vertical sectional view along the plane 9-9 in Figure 8; two pearls are dash-drawn in two housings of the device.

In the figures, a device is shown and generically referenced 10 and comprises a disc 12 equipped with a shaft 14 for rotation and angularly equidistant through holes 16 for positioning and fixing bolts (not shown). The device further comprises a support element 20, a mask element 30 and a cover element 40. The support element 20 is a disc-shaped element made of metal material, preferably aluminium, and comprises, on a circumference, housings 22, preferably angularly equidistant, each having a sufficient diameter to accommodate a gem to be marked. The arrangement of the housings could be different from that shown and the housings could be different from each other. The support 20 further comprises positioning and fixing holes 24 (henceforth also called centering holes).

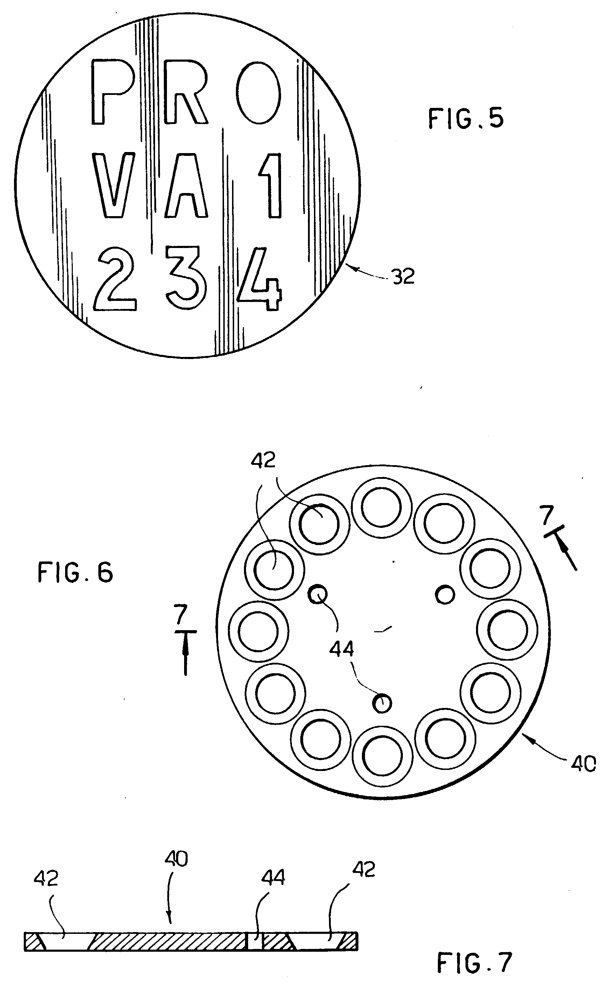

The mask 30 is generally made of metal material, preferably stainless steel, and comprises, in positions corresponding to the gem housing positions in the support, marking openings referenced 32. Such a marking opening is shown greatly enlarged in Figure 5, where it can be seen to comprise a combination of perforations, preferably laser microperforations, in form of letters and/or numbers, or in any case signs. The combination may comprise signs indicating the origin (which will then be the same on gems of the same origin) and/or signs to denote individual characteristics of the gem: The mask 30 further comprises centering holes, here referenced 34.

The cover 40 comprises through holes 42, preferably countersunk, with the narrower end disposed toward the inside and the flared end facing towards the outside, the narrower end preferably having the same diameter as the holes in the support. It further comprises centering holes 44.

The device is mounted on the disc 12 by means of bolts passing through the centering holes 24, 34, 44. The gems contained in the housings 22 thus present only the limited surfaces left free by the openings 32 in the mask 20 to the atmosphere of the environment in which the device is placed.

The procedure will be described below with particular reference to marking of pearls, it being understood that with suitable variants it can be used for precious and semi-precious stones.

A metal material, generally gold, platinum, copper or ITO (indium tin oxide) or titanium oxide, silicon dioxide, or magnesium fluoride, is used for marking deposition. The procedure is carried out in a vacuum chamber with an electrically heated crucible, of a type in itself known.

A support 20 assembled and loaded with one or more gems for to be marked is introduced into the vacuum chamber. The marking material, in the form of small flakes or in filaments, is then loaded therein, , with a total weight of about 1 kg, in a special cup or crucible, that acts as a hot source; the crucible is preferably of molybdenum, 0.1 mm thick, and the cup part is preferably circular in shape.

A door of the chamber is shut and a vacuum is created in the vacuum chamber. During the first stage, the pressure is lowered to a value of about 5 x 10⁻⁴mbar (5x10⁻² Pa).

Voltage is then applied to the crucible to raise the temperature of the cell slightly; this causes small amounts of water that may be present on the walls of the machine to evaporate. By allowing a current flow of about 1.5 A for a period of about 3 minutes, "degassing"or evaporation of any amounts of water is obtained.

On completion of "degassing" a further stage of the process can be started during which the pressure is first made to fall to a value of about 10⁻⁵mbar. The pressure is then increased to a value of 10⁻¹ mbar by introducing air by means of a manual control and at the same time a current of about 12 A is made to flow to a special aluminium cylinder in the machine; a beam of plasma or ionized air (or other ionized gas) is thus obtained which is used to achieve thorough cleaning of the surface of the pearl (or gem).

On completion of this stage the pressure is decreased to a value of 10⁻⁵ mbar at which deposition of the marking material starts; voltage is applied to the crucible, allowing a current flow of about 2 A for a period of about 30 seconds and a current flow of about 2.5 A for the next 20-30 seconds.

After the deposition stage and subsequent cooling of the system, the machine can be ventilated by introducing air into the chamber, and the gem(s) can thus be extracted.

When deposition has been carried out, a coat of varnish is applied to the surface involved with a brush to fix the deposited material on the gem. A preferred varnish is the Marbo M TOP ECO 521 type produced by MARBO ITALIA S.p.A.

The invention has been described in a preferred embodiment. Nevertheless provision is made for it to be realized with numerous variants, some of which are listed below.

The gems can be cleaned (with acetone or other degreasing agents) before loading into the machine.

The distance between the crucible and the support device, preferably about 50 mm, can vary.

The number of revolutions of the support device during deposition, is preferably about 60 rpm, but can be different.

The temperatures, heating times and pressures for the degassing stage can differ from what is indicated for the example described.

The temperatures and times of the plasma stage (preferably a time of 3 minutes at a pressure of about 10⁻⁵ mbar with a 5A current) can be different.

The temperatures and times of the degassing stage (preferably a time of 1 min at a pressure of about 10⁻⁵ mbar with 2A current and 30 seconds with 2.5A current) can be different.

The degree of vacuum during all the stages can differ with respect to the example described.

## Claims

1. A procedure for marking gems characterized in that it comprises the following steps of:
a) placing one or more gems to be marked in a vacuum chamber, leaving only selected surfaces of each gem exposed;
b) placing a marking material inside a heatable crucible in the same vacuum chamber;
c) creating a degree of vacuum inside the vacuum chamber;
d) heating said crucible until at least part of the marking material is in a vapor state.

2. A procedure according to claim 1, characterized in that, before said marking material vaporization step, it comprises a "plasma" step, wherein heating is effected to obtain a plasma of air or another gas for cleaning the surface of the gem.

3. A procedure according to claim 2, characterized in that it comprises, before said "plasma" step, an "evaporation" step comprising preliminary heating of the machine to evaporate any small amounts of water present.

4. A procedure according to claim 2, characterized in that to create said plasma the pressure is increased to a value in the order of 10⁻¹ mbar (about 10⁴ Pa), by introducing air or another gas, and the machine is heated by allowing a current flow of about 5 A.

5. A procedure according to claim 1, characterized in that a negative pressure of the order of 10⁻⁵ mbar (1 Pa) is created in the step c).

6. A procedure according to claim 1, characterized in that in step d) a current of 2A is applied to the crucible, for about a minute, or a current of 2.5 A for about 30 seconds.

7. A procedure according to claim 1, characterized in that it comprises a ventilation and cooling step after said heating step d).

8. A procedure according to claim 1 further comprising a varnishing step, wherein a coat of varnish is applied to the marked surface of a gem.

9. A procedure according to claim 1, characterized in that it comprises cleaning of the gems with acetone or another degreasing agent before introduction into the vacuum chamber.

10. A procedure according to claim 1, characterized in that the gems are moved when in said vacuum chamber.

11. A procedure according to claim 10 characterized in that the movement is a setting in rotation at about 60 revs/min.

12. A procedure according to claim 1, characterized in that the marking material is one of the following: gold, platinum, indium tin oxide, known as ITO, titanium oxide, silicon dioxide, magnesium fluoride.

13. A gem marked with the procedure according to any one of the preceding claims.

14. A gem holding device for holding gem/s during marking thereof characterized in that it comprises: a support element (20) equipped with housings (22) to accommodate the gems, and a mask element (30) to be applied to the support element and provided with microperforations (32) corresponding to the marking to be applied to the gem/s.

15. A device according to the preceding claim characterized in that it further comprises a disc element with means for rotation and a cover (40) provided with holes (42) in the same number and position as the housings in the support, all these elements being provided with positioning holes for overall assembly in a predetermined angular position with respect to each other.

16. A device according to the preceding claim characterized in that the holes (42) in the cover are countersunk, with the end with a smaller diameter facing towards the mask element, when the device is assembled.

17. A device according to claim 14, characterized in that the support is made of aluminium, the cover is of aluminium and the mask of stainless steel.
